# EUROPEAN PATENT SPECIFICATION

(11) **EP 2 681 719 B1**
(45) Date of publication and mention of the grant of the patent: **20.05.2020**
(21) Application number: 12752834.7
(22) Date of filing: 22.02.2012
(51) Int. Cl.: G06T 17/05, G08G 5/00, G06F 17/50

(54) **AN INTEGRATED TERRAIN MODELLING SYSTEM**
INTEGRIERTES GELÄNDEMODELLIERUNGSSYSTEM
SYSTÈME DE MODÉLISATION DE TERRAIN INTÉGRÉ

(30) Priority: 28.02.2011 AU 2011900689
(43) Date of publication of application: 08.01.2014
(73) Proprietor: Leica Geosystems AG, 9435 Heerbrugg (CH)
(72) Inventor: ROBERTSON, Craig Anthony, Dutton Park Queensland 4102 (AU)
(74) Representative: Kaminski Harmann
(86) International application number: PCT/AU2012/000170
(87) International publication number: WO 2012/116392

(56) References cited:
- US-A1- 2007 123 249
- US-A1- 2008 221 843
- US-A1- 2009 202 109
- US-A1- 2009 256 412
- MICHAEL F GOODCHILD: "Citizens as sensors: the world of volunteered geography", GEOJOURNAL, KLUWER ACADEMIC PUBLISHERS, DO, vol. 69, no. 4, 20 November 2007 (2007-11-20), pages 211-221, XP019551430, ISSN: 1572-9893, DOI: 10.1007/S10708-007-9111-Y

## Description

### FIELD OF THE INVENTION

The invention relates to an integrated terrain modelling system. In particular, although not exclusively, the invention relates to an integrated terrain modelling system which seamlessly integrates geodetic data from different measuring devices such as GNSS survey rovers, total stations, laser scanners, machine guidance systems, autonomous machines, radar devices and aerial photogrametery apparatus. The geodetic data updates a digital terrain model of a mine site in real time or near-real time.

### BACKGROUND TO THE INVENTION

Terrain modelling of a changing terrain is well known in the open pit mining industry. A mine site, or at least part of it, is surveyed from time to time (usually end of month) using site survey equipment such as laser scanners and total stations to build a terrain model of the mine site. The terrain model is used by engineers and planners to manage the mine and to accurately determine the volume of material moved.

Patent application US2009/0202109 A1 discloses a terrain mapping system comprising a terrain map in an off-board system remote from the worksite and a plurality of sensors mounted on worksite infrastructure or machines. Data collected from the sensors is transformed into a common coordinate system and used to update the terrain model.

### OBJECT OF THE INVENTION

It is an object of the invention to overcome or at least alleviate one or more of the above problems and/or provide the consumer with a useful or commercial choice.

### DISCLOSURE OF THE INVENTION

The invention resides in an integrated terrain modelling system as defined by claim 1.

The integration system preferably includes a conversion module located on-board the field units, the conversion module operable to convert the geodetic data generated by the field units into the common format.

The conversion module may be located at the central server and be operable to receive geodetic data of different formats from the different field units and convert the geodetic data into the common format at the site module in real or near-real time.

Suitably, the integration system is configured to provide a weighting when manipulating the geodetic data of the different field units when using that data to update the terrain model.

Preferably, the geodetic data of field units that provide higher accuracy geodetic data will have a higher weighting than the geodetic data of field units that provide lower accuracy geodetic data when the geodetic data, once converted to the common data formant, is used to update the terrain model of the site.

The field units preferably include GNSS survey rovers, total stations, laser scanners, machine guidance systems, autonomous machines, radar devices and aerial photogrametery apparatus.

The site module is preferably located at a central server.

The field units preferably each include a database storing a terrain model and wherein the integrated terrain modelling system includes a distributed database management system to keep the terrain model in the databases of the field units current and the terrain model in the site module current.

The communications system and integration system are preferably adapted so that terrain model at the site module is updated in real or near-real time as the geodetic data is received at the central server.

The integrated terrain modelling system may include the field units.

The network is preferably a wireless network and the communications system is preferably adapted to provide wireless data communication.

The communications system preferably comprises a wireless communications module at the central server and a wireless communications module at each of the field units.

In another form, the invention resides in a method of updating an integrated terrain model of a site as defined by claim 9.

The method preferably includes manipulating the geodetic data on-board the field units to be in the common format before transmission of the geodetic data to the central server.

The method may include transmission of the geodetic data from the field units in the different formats and then manipulating the geodetic data at the site module to be in the common format.

The method preferably includes distributing the updated integrated terrain model from the site module to each of the field units.

### BRIEF DESCRIPTION OF THE DRAWINGS

To assist in understanding the invention and to enable a person skilled in the art to put the invention into practical effect, preferred embodiments of the invention will be described by way of example only with reference to the accompanying drawings, wherein:
FIG 1 shows a diagram of an integrated terrain modelling system in accordance with one embodiment of the invention;
FIG 2 shows a front view of GNSS survey rover of the integrated terrain modelling system of FIG 1;
FIG 3 shows a perspective view of a total station of the integrated terrain modelling system of FIG 1;
FIG 4 shows a perspective view of a laser scanner of the integrated terrain modelling system of FIG 1;
FIG 5 shows a side view of earth moving equipment including a precision machine guidance system of the integrated terrain modelling system of FIG 1;
FIG 6 shows a diagrammatic view of one embodiment of the integrated terrain modelling system of FIG 1 and the flow of data in the integrated terrain modelling system;
FIG 7 shows a diagrammatic view of another embodiment of the integrated terrain modelling system of FIG 1 and the flow of data in the integrated terrain modelling system;
FIG 8 shows a diagrammatic flow diagram of a method of integrated terrain modelling in accordance with an embodiment of the invention; and
FIG 9 shows a diagram of distributing an updated integrated terrain model from a central server to different field units of the integrated terrain modelling system of FIG 1.

### DETAILED DESCRIPTION OF THE INVENTION

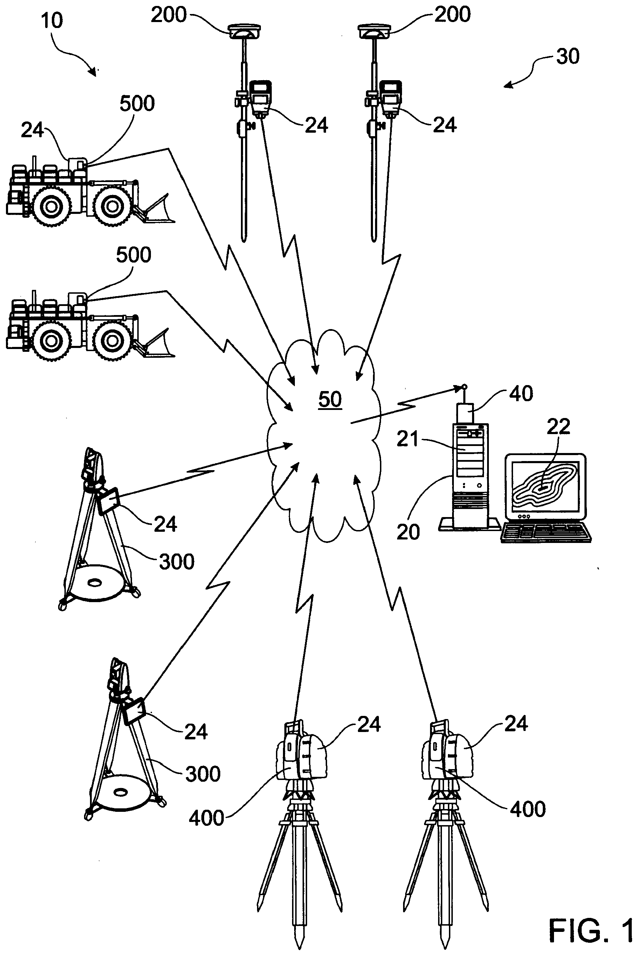

Referring to FIG 1, an integrated terrain modelling system 10 includes a central server 20 and four types of field units 30. Any reference in this patent specification to a field unit must be interpreted broadly to include a rover unit, an autonomous machines, radar apparatus and aerial photogrametry apparatus. By way of example different types of field units 30 shown in FIG 1 are GNSS survey rovers 200, total stations 300, laser scanners 400 and precision machine guidance systems 500. Two of each of the different types of field units 200, 300, 400, 500 are shown. The field units 30 are in wireless communication with a site module 21 of the central server 20 via a wireless network 50. The system 10 includes a wireless communications module 40 at the central server 20 facilitating wireless communication between the site module 21 and the field units 30. Wireless communication may be over any of Wi-Fi, CDMA, GSM, 3G, 4G or other networks. As such, the wireless communications module 40 may be a data modem and wireless communications modules of the field units 30 are also data modems.

Each field unit 30 is operable to upload geodetic data generated by the field unit 30 to the central server 20 via the wireless network 50. The geodetic data may be uploaded in real or near-real time or upload may depend on the wireless communication connection. Mine sites may not have network coverage over the entire site. The geodetic data recorded by the field units 30 may be stored onboard the field units 30 until such a time as a wireless data connection with the central server 20 is established, at which time the stored data is transmitted to the site module 21 at the central server 20.

The site module 21 includes a database having a digital terrain model 22 of the mine site on which the field units 30 operate. The digital terrain model 22 is saved in the database in a memory of the site module 21. The terrain model 22 is updated with geodetic data received from the field units 30 as described.

Each of the field units 30 has a measuring device in the form of a sensor operable to generate raw geodetic data, usually in the form of point data. The different types of field units have different types of sensors generating geodetic data in different formats. Point data is generally raw XYZ co-ordinates which are formatted and/or converted into geodetic data of one or a number of different formats. The different formats of geodetic data are not easily integrateable. For this reason, the system 10 includes data conversion modules 24 at each of the field units 30. The data conversion modules 24 are operable to convert the geodetic data of different formats in real or near-real time into integrateable data of a common format to update the terrain model 22. The data conversion modules 24 together form part of an integration system operable to manipulate the geodetic data of the different formats in real or near-real time to be in the common format to update the terrain model 22. Conversion of the geodetic data of the different types of field units 30 is more specifically described hereinbelow with reference to the GNSS survey rovers 200, total stations 300, laser scanners 400 and precision machine guidance systems 500.

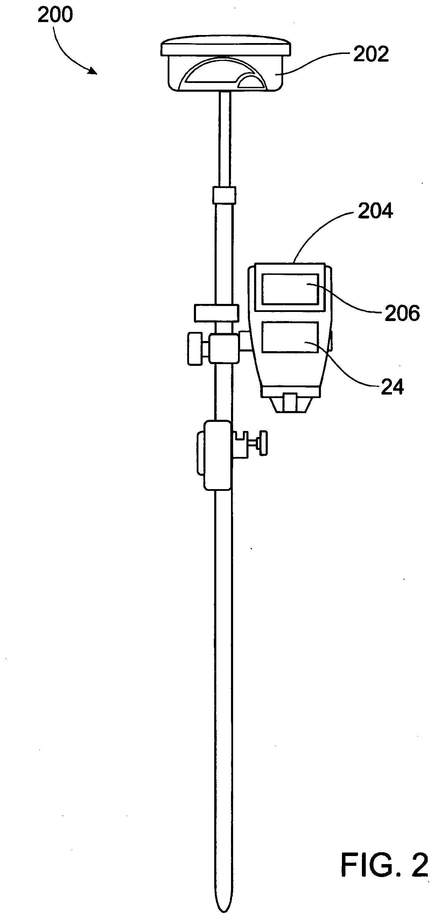

FIG 2 shows a front view of the GNSS survey rover 200. The GNSS survey rover 200 comprises a sensor in the form of a GNSS receiver 202, a controller 204, wireless communication module 206 and data conversion module 24. The GNSS receiver 202 is operable to receive GNSS signals from GNSS satellites. The GNSS signals are communicated to the controller 204 where the signals are used to generate accurate location point data of the rover 200. The location point data is formatted into geodetic data of, for example, the dbx format. The geodetic data is converted by the conversion module 24 as described and transmitted to the central server 20 by the wireless communication module 206. The dbx format may be the common format for the field units 30, in which case the geodetic data is not further converted by the conversion module 24.

The controller 204 includes a memory having a database in which a terrain model of the site is stored. The terrain model is updated by the location point data surveyed by the rover 200 and also by updated terrain model data received from the server 20.

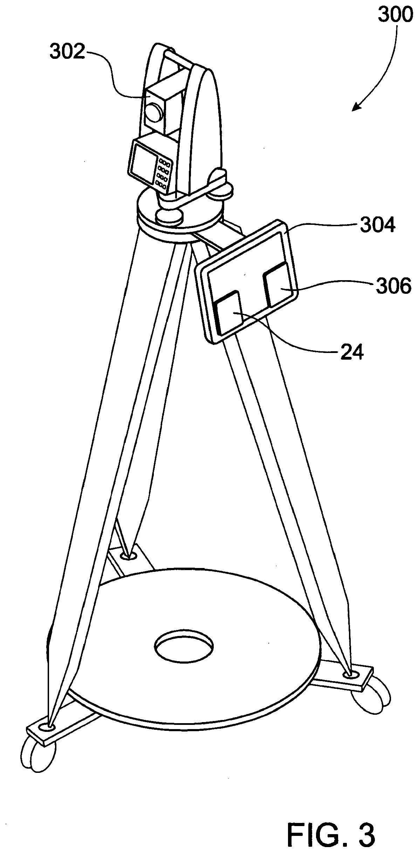

FIG 3 shows a perspective view of the total station 300. The total station 300 comprises a sensor in the form of an electronic transit and electronic distance measuring device (EDM) 302. The total station 300 is used to determine angles and distances from the total station 300 to points to be surveyed. With the aid of trigonometry, the angles and distances may be used to calculate raw geodetic data in the form of point data (x, y, and z or northing, easting and elevation) of surveyed points in absolute terms. The total station 300 also includes a controller 304, wireless communication module 306 and data conversion module 24. The point data is commonly formatted in dbx format as geodetic data. The geodetic data is uploaded to the central server 20 via the wireless communication module 306. The geodetic data is converted to the common format by the conversion module 24 before being transmitted. If the common format for integration of data is the dbx format then the conversion module may not convert the geodetic data.

The controller 304 includes a memory in which a terrain model of the site is stored. The terrain model is updated by the point data surveyed by the total station 300 and also by the updated terrain model data received from the server 20. In one example, the total station 300 is a model Leica TPS1200+ total station.

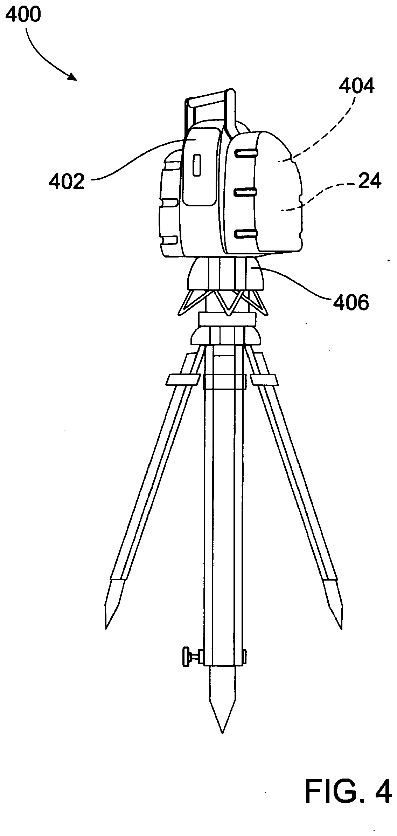

FIG 4 shows a perspective view of the laser scanner 400. The laser scanner 400 has a sensor in the form of a rotatable head 402 which is operable to scan the mine site to collect distance information about surfaces within the head's 402 field of view. The scanner 400 generates geodetic data in the form of point clouds. The point clouds are formatted in pts 3D point cloud data format. The scanner 400 includes a controller 404, wireless communication module 406 and data conversion module 24. The data in pts format is converted to a common format by the data conversion module 24. The geodetic data is transmitted to the central server 20 over the wireless network 50. In one example, the laser scanner 400 is a Leica HDS4400 scanner specifically developed for mining survey.

The controller 404 includes a memory having a database in which a terrain model of the site is stored. The terrain model is updated by the point cloud data generated by the scanner 400 and also by updated terrain model data received from the central server 20.

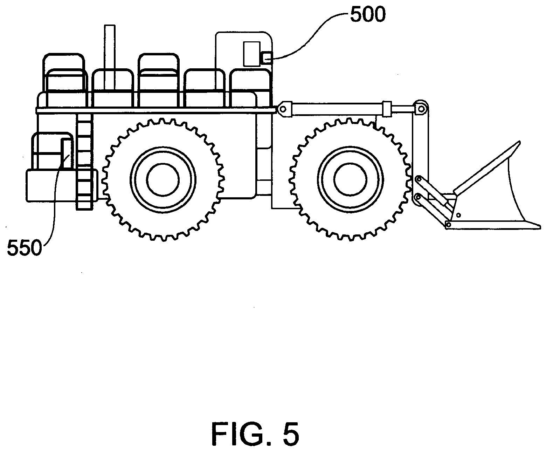

FIG 5 shows a side view of an earth moving vehicle 550 having the precision machine guidance system 500. The precision machine guidance system 500 includes a GNSS receiver, controller, wireless communication module and data conversion module. The guidance system 500 has a memory having a database storing a terrain model in the form of a dynamic surface (referred to as the "as built surface") which updates as the vehicle 550 passes through the as built surface. The guidance system generates and stores point data in custom ASCII data output format. The data in ASCII format is converted to the common format by the data conversion module of the machine guidance system 500. The geodetic data is transmitted to the central server 20 over the wireless network 50.

The dynamic surface is updated by the point data generated via the GNSS receiver and also by updated terrain model data received from the central server 20.

The GNSS receiver 202, EDM 302 and head 402 and GNSS receiver of the guidance system 500 are all different types of sensors.

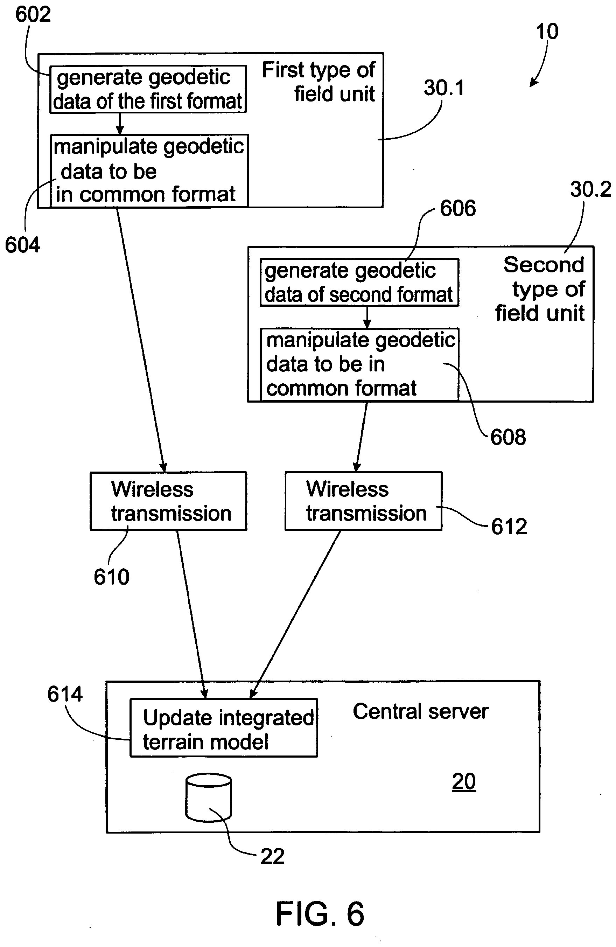

Referring to FIG 6, a block diagram of the integrated terrain modelling system 10 and the flow of data in the system 10 is shown. A first type of field unit 30.1 generates geodetic data of a first format at step 602. The geodetic data of the first format is manipulated by data format conversion on-board the first type of field unit 30.1 by the conversion module 24 at step 604. The geodetic data of the first format is converted to the common format for updating the terrain model 22. Similarly, a second type of field unit 30.2 generates geodetic data of a second format at step 606. The geodetic data of the second format is manipulated by data format conversion on-board the second type of field unit 30.2 by the conversion module 24 at step 608. The raw geodetic data of the second format is converted to be data of the common format for updating the terrain model 22.

The geodetic data of the first format is generated by either the GNSS survey rover 200, the total station 300, the laser scanner 400 or the machine guidance system 500. The geodetic data of the second format is generated by one of the GNSS survey rover 200, the total station 300, the laser scanners 400 or the machine guidance systems 500 other than the geodetic data generating equipment which generated the geodetic data of the first format. It will be appreciated that each type of field unit 30 may generate a different format of geodetic data from a different type of sensor, although only two formats of geodetic data are described with reference to FIG. 6.

The integrateable data of the two different types of geodetic data generating equipment 30.1, 30.2 is wirelessly transmitted to the central server 20 as indicated by blocks 610, 612 respectively.

The integrated terrain model 22 is updated in real or near-real time when received at the central server 20 at step 614 with the commonly formatted data of the two different types of field units 30.1, 30.2.

The block diagram of Fig 6 describes the integrated terrain modeling system 10 with reference to conversion of geodetic data on-board the field units 30. It will be appreciated by those skilled in the art that the conversion of the geodetic data into the common format to be seamlessly integrateable may be performed at the central server 20.

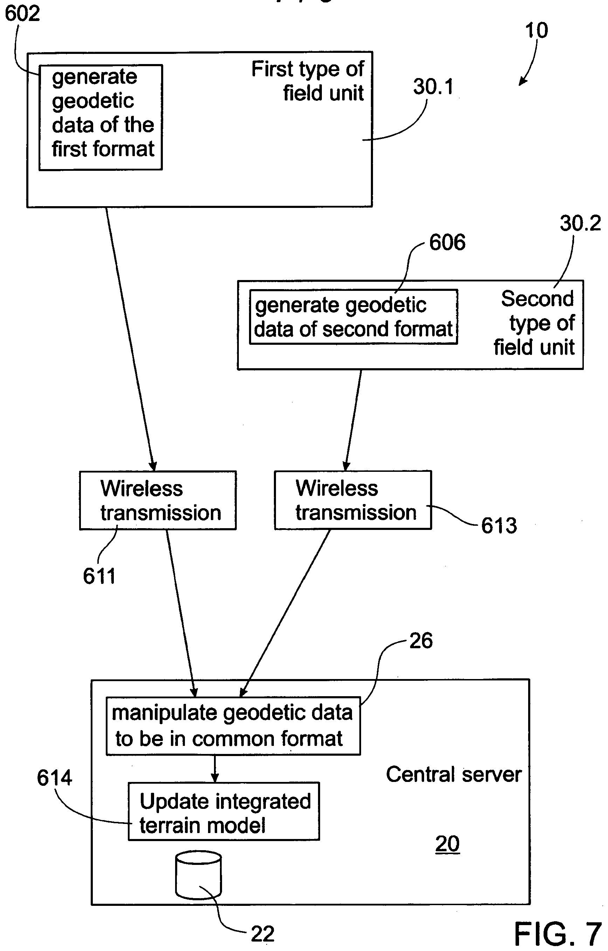

Fig 7 shows a block diagram of the central server 20 including a conversion module 26 which converts geodetic data of different formats to integrateable data of a common format at the central server 20.

The first type of field unit 30.1 generates geodetic data of the first format at step 602.

The geodetic data of the first format is manipulated by data format conversion on-board the first type of field unit 30.1 by the conversion module 24 at step 604. The second type of field unit 30.2 generates geodetic data of the second format at step 606. The geodetic data of the different formats is wirelessly transmitted 611, 613 to the central server 20 without on-board processing at the field units 30.1, 30.2. The geodetic data is received at the conversion module 26 at the central server 20, where the geodetic data is manipulated to be in a common format. The geodetic data in the common format updates the integrated terrain model at step 614.

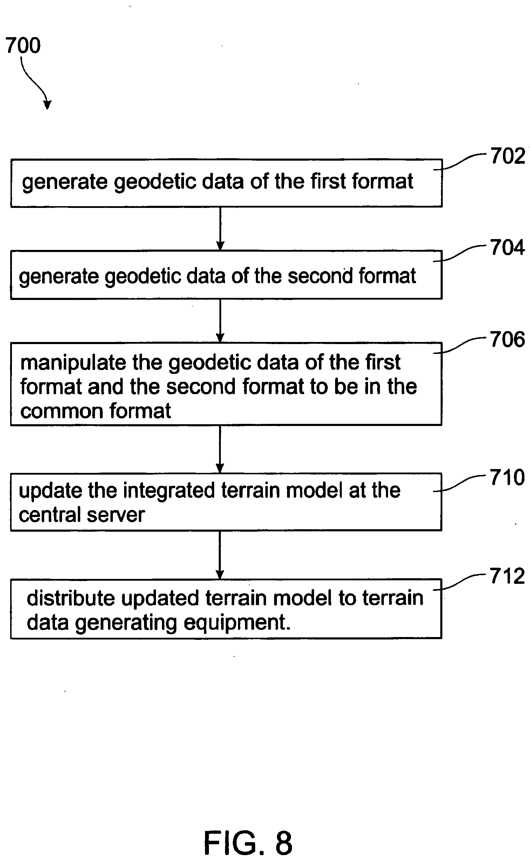

FIG. 8 is a diagrammatic flow diagram of the method 700 of updating the integrated terrain model 22.

The method 700 comprises generating geodetic data of the first format at step 702. The geodetic data of the first format is generated using the first type of field unit 30.1 referred to in FIG's 6 and 7.

Geodetic data of the second format is generated at step 704. The geodetic data of the second format is generated using the second type of field unit 30.2 referred to in FIG' 6 and 7.

The geodetic data of the first format and the second format is manipulated by data format conversion at step 706 to be integrateable geodetic data which is in a common format. The geodetic data of the different formats may be manipulated on-board the respective field units 30.1 and 30.2 as described with reference to FIG 6 or be manipulated at the central server 20 as described with reference to FIG 7.

The integrated terrain model 22 is seamlessly updated at the central server 20 with the commonly formatted geodetic as the data is received at the server 20.

The updated terrain model 22 as updated is distributed back from the central server 20 to each of the field units 30 at step 712. Distribution may be scheduled or event triggered.

The integrated terrain model 22 on the central server 20 is a master terrain model which is duplicated to the field units 30. The central server 20 includes a distributed database management system which manages distribution of the master terrain model 22 (or part thereof) to the field units 30 and the update of the integrated terrain model of the central server 20. Distribution of the terrain model 22 to all of the field units 30 keeps the terrain model current in all the field units 30.

The advantage of using a distributed database system is that the field units 30 are able to continue updating the terrain models in their own databases as required when the field units are out of communication range with the central server 20. The terrain model 22 is only updated from the central server 22 to the field units 30 as required to reduce unnecessary data replication.

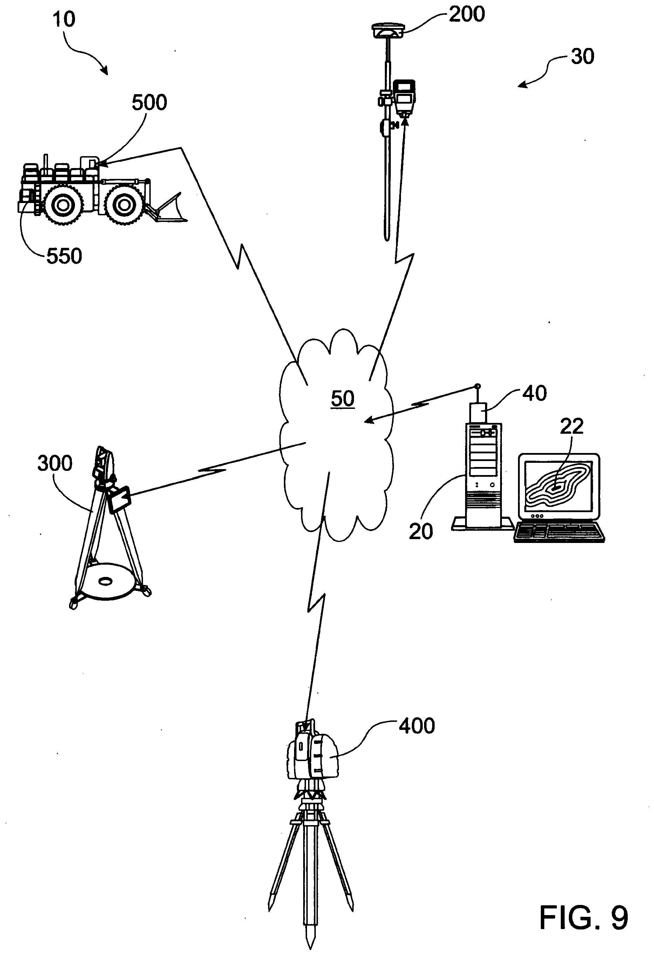

FIG 9 shows a diagram of how the updated terrain model 22 saved in a database of the central server 20 is distributed by duplication to the field units 30. The terrain model 22 is wirelessly transmitted to each of the survey rover 200, total station 300, laser scanner 400 and the machine guidance system 500. The updated terrain model 22 is saved in the database of each of the field units 30.

The integrated terrain modelling system 10 provides real time or near-real time data exchange of geodetic data between the office and the field. This has the benefit that an accurate updated digital terrain model 22 is continuously maintained, which negates the need for end of month surveys. Using the updating of the terrain model 22, volumetric productivity of the mine can be calculated in real time. The geodetic data sets from the field units is seamlessly merged in real or near-real time rather than the cumbersome and time consuming manual merging of multiple data sets of different formats as is presently known. The terrain model 22 is distributed to the field units 30 to allow field operators, planners, engineers, and surveyors up to date information of the mine site.

In further forms still falling within the scope of this document the integration system is configured to provide a weighting when manipulating the geodetic data of the different field units when using that data to update the terrain model.

Preferably, the geodetic data of field units that provide higher accuracy geodetic data will have a higher weighting than the geodetic data of field units that provide lower accuracy geodetic data when the geodetic data, once converted to the common data formant, is used to update the terrain model of the site. For example, aerial photogrametery may only be used to update the site model once a month but will be assigned a higher weighting that, for example, position information from a vehicle or the like.

In this specification, the terms "comprise", "comprises", "comprising" or similar terms are intended to mean a non-exclusive inclusion, such that a system, method or apparatus that comprises a list of elements does not include those elements solely, but may well include other elements not listed.

The reference to any prior art in this specification is not, and should not be taken as, an acknowledgement or any form of suggestion that the prior art forms part of the common general knowledge.

## Claims

1. An integrated terrain modeling system (10) comprising:
a site module (21), the site module (21) including a database having a terrain model (22) of a site;
a first field unit (30), the first field unit (30) including a sensor operable to generate geodetic data of the site formatted in a first format;
a further field unit (30), the further field unit (30) including a sensor operable to generate geodetic data of the site formatted in a further format;
an integration system including at least one conversion module operable to manipulate the geodetic data generated by the first field unit (30) and the further field unit (30) to be in a common geodetic data format; and
a distributed database management system that seamlessly integrates the geodetic data in the common geodetic data format at the site module (21) to update the terrain model (22) in real time or near-real time and distributes the terrain model to the field units.

2. The integrated terrain modeling system (10) of claim 1, wherein a conversion module (24) is located on-board each of the field units (30), the conversion modules (24) operable to manipulate the geodetic data generated by a respective field unit (30) to be in the common geodetic data format.

3. The integrated terrain modeling system (10) of claim 1 further comprising a conversion module (24) located at the site module (21), the conversion module (24) operable to receive geodetic data of the first format and geodetic data of the further format and convert the geodetic data into the common geodetic data format at the site module (21) in real or near-real time.

4. The integrated terrain modeling system (10) of claim 1 further comprising a communications system adapted to provide data communication between the site module (21), the first field unit (30) and the further field unit (30).

5. The integrated terrain modeling system (10) of claim 1, wherein the field units (30) are of the form of one of GNSS survey rovers, total stations, laser scanners or machine guidance systems.

6. The integrated terrain modeling system (10) of claim 1 further comprising one or more of the further field units (30).

7. The integrated terrain modeling system (10) of claim 1, wherein the site module (21) is located at a central server (20) of the integrated terrain modeling system (10).

8. The integrated terrain modeling system (10) of claim 1, wherein each field unit (30) includes a database storing a terrain model (22) and wherein the distributed database management system is configured to keep the terrain model (22) in each database of the field units current and is further configured to keep the terrain model (22) of the site in the site module (21) current.

9. A method of updating an integrated terrain model (22) of a site, the method (22) including the steps of:
generating (602, 702) geodetic data of at least a portion of the site in a first format at a measuring device of a first field unit (30);
generating geodetic (606, 704) data of at least a portion of the site in a further format at a measuring device of a further field unit (30), the measuring device of the further field unit (30);
manipulating (604, 608, 26, 706) the geodetic data generated by the first field unit and the further field unit to each be in a common geodetic data format; and
integrating the geodetic data in the common geodetic data format;
updating (614, 710) the integrated terrain model (22) at a site module (21); and distributing the terrain model (22) to the field units (3).

10. The method of claim 9 further including the step of communicating the geodetic data which has been manipulated to be in a common geodetic data format to the site module (21) prior to integrating the geodetic data in the common geodetic data format to update the integrated terrain model (22).

11. The method of claim 9 further including the step of communicating the geodetic data in the first format from the first field unit (30) and in the further format from the further field unit (30) to the site module (21) prior to manipulating the geodetic data to be in the common geodetic data format.

12. The method of claim 9 further including the step of communicating (712) the updated integrated terrain model from the site module (21) to each of the field units (30).

## Patentansprüche

1. Integriertes Geländemodellierungssystem (10), umfassend:
ein Standortmodul (21), wobei das Standortmodul (21) eine Datenbank beinhaltet, die ein Geländemodell (22) eines Standorts aufweist;
eine erste Feldeinheit (30), wobei die erste Feldeinheit (30) einen Sensor beinhaltet, der dafür betreibbar ist, geodätische Daten des Standorts zu erzeugen, die in einem ersten Format formatiert sind;
eine weitere Feldeinheit (30), wobei die weitere Feldeinheit (30) einen Sensor beinhaltet, der dafür betreibbar ist, geodätische Daten des Standorts zu erzeugen, die in einem weiteren Format formatiert sind;
ein Integrationssystem, das wenigstens ein Umwandlungsmodul beinhaltet, das dafür betreibbar ist, die durch die erste Feldeinheit (30) und die weitere Feldeinheit (30) erzeugten geodätischen Daten derart zu verarbeiten, dass sie in einem gemeinsamen geodätischen Datenformat sind; und
ein verteiltes Datenbankverwaltungssystem, das die geodätischen Daten in dem gemeinsamen geodätischen Datenformat im Standortmodul (21) nahtlos integriert, um das Geländemodell (22) in Echtzeit oder nahezu Echtzeit zu aktualisieren, und das das Geländemodell auf die Feldeinheiten verteilt.

2. Integriertes Geländemodellierungssystem (10) nach Anspruch 1, wobei sich ein Umwandlungsmodul (24) an Bord von jeder der Feldeinheiten (30) befindet, wobei die Umwandlungsmodule (24) dafür betreibbar sind, die durch eine jeweilige Feldeinheit (30) erzeugten geodätischen Daten derart zu verarbeiten, dass sie in dem gemeinsamen geodätischen Datenformat sind.

3. Integriertes Geländemodellierungssystem (10) nach Anspruch 1, ferner umfassend ein Umwandlungsmodul (24), das sich im Standortmodul (21) befindet, wobei das Umwandlungsmodul (24) dafür betreibbar ist, geodätische Daten des ersten Formats und geodätische Daten des weiteren Formats zu empfangen und die geodätischen Daten im Standortmodul (21) in Echtzeit oder nahezu Echtzeit in das gemeinsame geodätische Datenformat umzuwandeln.

4. Integriertes Geländemodellierungssystem (10) nach Anspruch 1, ferner umfassend ein Übertragungssystem, das dafür eingerichtet ist, eine Datenübertragung zwischen dem Standortmodul (21), der ersten Feldeinheit (30) und der weiteren Feldeinheit (30) bereitzustellen.

5. Integriertes Geländemodellierungssystem (10) nach Anspruch 1, wobei die Feldeinheiten (30) in der Form von einem aus GNSS-Vermessungsrovern, Totalstationen, Laserscannern oder Maschinenleitsystemen vorliegen.

6. Integriertes Geländemodellierungssystem (10) nach Anspruch 1, ferner umfassend eine oder mehrere der weiteren Feldeinheiten (30).

7. Integriertes Geländemodellierungssystem (10) nach Anspruch 1, wobei sich das Standortmodul (21) in einem zentralen Server (20) des integrierten Geländemodellierungssystems (10) befindet.

8. Integriertes Geländemodellierungssystem (10) nach Anspruch 1, wobei jede Feldeinheit (30) eine Datenbank beinhaltet, in der ein Geländemodell (22) gespeichert ist, und wobei das verteilte Datenbankverwaltungssystem dafür ausgelegt ist, das Geländemodell (22) in jeder Datenbank der Feldeinheiten aktuell zu halten, und ferner dafür ausgelegt ist, das Geländemodell (22) des Standorts in dem Standortmodul (21) aktuell zu halten.

9. Verfahren zum Aktualisieren eines integrierten Geländemodells (22) eines Standorts, wobei das Verfahren (22) die folgenden Schritte beinhaltet:
Erzeugen (602, 702) von geodätischen Daten von wenigstens einem Abschnitt des Standorts in einem ersten Format in einer Messvorrichtung einer ersten Feldeinheit (30);
Erzeugen (606, 704) von geodätischen Daten von wenigstens einem Abschnitt des Standorts in einem weiteren Format in einer Messvorrichtung einer weiteren Feldeinheit (30), wobei die Messvorrichtung der weiteren Feldeinheit (30);
Verarbeiten (604, 608, 26, 706) der durch die erste Feldeinheit und die weitere Feldeinheit erzeugten geodätischen Daten, sodass sie jeweils in einem gemeinsamen geodätischen Datenformat sind; und
Integrieren der geodätischen Daten in dem gemeinsamen geodätischen Datenformat;
Aktualisieren (614, 710) des integrierten Geländemodells (22) in einem Standortmodul (21); und
Verteilen des Geländemodells (22) auf die Feldeinheiten (3) .

10. Verfahren nach Anspruch 9, ferner beinhaltend den Schritt des Übertragens der geodätischen Daten, die derart verarbeitet wurden, dass sie in einem gemeinsamen geodätischen Datenformat sind, an das Standortmodul (21), bevor die geodätischen Daten in dem gemeinsamen geodätischen Datenformat integriert werden, um das integrierte Geländemodell (22) zu aktualisieren.

11. Verfahren nach Anspruch 9, ferner beinhaltend den Schritt des Übertragens der geodätischen Daten in dem ersten Format von der ersten Feldeinheit (30) und in dem weiteren Format von der weiteren Feldeinheit (30) an das Standortmodul (21), bevor die geodätischen Daten derart verarbeitet werden, dass sie in dem gemeinsamen geodätischen Datenformat sind.

12. Verfahren nach Anspruch 9, ferner beinhaltend den Schritt des Übertragens (712) des aktualisierten integrierten Geländemodells von dem Standortmodul (21) zu jeder der Feldeinheiten (30).

## Revendications

1. Système intégré de modélisation de terrain (10) comprenant :
un module de site (21), ledit module de site (21) incluant une base de données contenant un modèle de terrain (22) d'un site ;
une première unité de terrain (30), ladite première unité de terrain (30) incluant un capteur apte à générer des données géodésiques du site formatées à un premier format ;
une autre unité de terrain (30), ladite autre unité de terrain (30) incluant un capteur apte à générer des données géodésiques du site formatées à un autre format ;
un système d'intégration incluant au moins un module de conversion apte à manipuler les données géodésiques générées par la première unité de terrain (30) et l'autre unité de terrain (30) d'être dans un format commun de données géodésiques ; et
un système de gestion de base de données répartie qui intègre sans rupture les données géodésiques audit format commun de données géodésiques, auprès du module de site (21), afin d'actualiser le modèle de terrain (22) en temps réel ou en temps quasi réel, et qui répartit le modèle de terrain sur les unités de terrain.

2. Système intégré de modélisation de terrain (10) selon la revendication 1, dans lequel un module de conversion (24) est situé à bord de chacune des unités de terrain (30), chacun desdits modules de conversion (24) étant apte à convertir les données géodésiques générées par l'unité de terrain (30) correspondante vers ledit format commun de données géodésiques.

3. Système intégré de modélisation de terrain (10) selon la revendication 1, comprenant en outre un module de conversion (24) situé auprès du module de site (21), ledit module de conversion (24) étant apte à recevoir des données géodésiques audit premier format et des données géodésiques audit autre format, et à convertir les données géodésiques vers ledit format commun de données géodésiques, auprès du module de site (21), en temps réel ou en temps quasi réel.

4. Système intégré de modélisation de terrain (10) selon la revendication 1, comprenant en outre un système de communication conçu pour fournir une communication de données entre le module de site (21), la première unité de terrain (30) et l'autre unité de terrain (30).

5. Système intégré de modélisation de terrain (10) selon la revendication 1, dans lequel les unités de terrain (30) prennent la forme de cannes GNSS, de stations totales, de numériseurs laser et/ou de systèmes de guidage de machine.

6. Système intégré de modélisation de terrain (10) selon la revendication 1, comprenant en outre une ou plusieurs desdites autres unités de terrain (30).

7. Système intégré de modélisation de terrain (10) selon la revendication 1, dans lequel le module de site (21) est situé auprès d'un serveur central (20) dudit système intégré de modélisation de terrain (10).

8. Système intégré de modélisation de terrain (10) selon la revendication 1, dans lequel chaque unité de terrain (30) comprend une base de données où est enregistré un modèle de terrain (22), et dans lequel le système de gestion de base de données répartie est conçu pour que le modèle de terrain (22) de chaque base de données des unités de terrain soit le modèle de terrain courant, et également conçu pour que le modèle de terrain (22) du site du module de site (21) soit le modèle de terrain courant.

9. Procédé d'actualisation d'un modèle intégré de terrain (22) d'un site, ledit procédé incluant les étapes suivantes :
génération (602, 702) des données géodésiques d'au moins une partie du site à un premier format auprès d'un dispositif de mesure d'une première unité de terrain (30) ;
génération (606, 704) des données géodésiques d'au moins une partie du site à un autre format auprès d'un dispositif de mesure d'une autre unité de terrain (30), le dispositif de mesure de l'autre unité de terrain (30);
manipulation (604, 608, 26, 706) des données géodésiques générées par la première unité de terrain et de celles générées par l'autre unité de terrain d'être dans un format commun de données géodésiques ;
intégration des données géodésiques audit format commun de données géodésiques ;
actualisation (614, 710) du modèle intégré de terrain (22) auprès d'un module de site (21) ; et
répartition du modèle de terrain (22) sur les unités de terrain (30).

10. Procédé selon la revendication 9 incluant en outre l'étape de communication, au module de site (21), des données géodésiques qui ont été converties vers ledit format commun de données géodésiques, avant l'intégration des données géodésiques audit format commun de données géodésiques pour actualiser le modèle intégré de terrain (22).

11. Procédé selon la revendication 9 incluant en outre l'étape de communication, au module de site (21), des données géodésiques audit premier format issues de la première unité de terrain (30) et audit autre format issues de l'autre unité de terrain (30), avant la conversion des données géodésiques vers ledit format commun de données géodésiques.

12. Procédé selon la revendication 9 incluant en outre l'étape de communication (712), à chacune des unités de terrain (30), du modèle intégré de terrain actualisé issu du module de site (21).
